Europäisches Patentamt

European Patent Office

Office européen des brevets

(19)

(11) Numéro de publication: **0 233 577**
**B1**

(12) **FASCICULE DE BREVET EUROPEEN**

(45) Date de publication du fascicule du brevet:
25.04.90

(51) Int. Cl.⁴: **B61C 17/04,** B61C 5/02,
B61C 3/00

(21) Numéro de dépôt: **87101838.8**

(22) Date de dépôt: **10.02.87**

(54) **Dispositif de ventilation des radiateurs de fluide et/ou des rhéostats d'une locomotive.**

(30) Priorité: **11.02.86 FR 8601847**
**27.01.87 FR 8700939**

(43) Date de publication de la demande:
**26.08.87 Bulletin 87/35**

(45) Mention de la délivrance du brevet:
**25.04.90 Bulletin 90/17**

(84) Etats contractants désignés:
**AT BE CH DE ES FR GB GR IT LI NL SE**

(56) Documents cités:
**CH-A- 115 452**
**CH-A- 137 627**
**CH-A- 256 999**
**FR-A- 884 217**
**FR-A- 1 591 809**
**GB-A- 390 215**
**US-A- 3 322 932**

(73) Titulaire: **GEC ALSTHOM SA, 38, avenue Kléber,**
**F-75116 Paris(FR)**

(72) Inventeur: **Dumas, Jean-Claude, 1, allée Alfred Sisley,**
**F-95230 Soisy sous Montmorency(FR)**
Inventeur: **Thoraval, Maurice, 9, allée des Amandiers,**
**F-95100 Argenteuil(FR)**
Inventeur: **Genuit, Gérard, 36, rue Edgar Quinet,**
**F-95870 Bezons(FR)**

(74) Mandataire: **Weinmiller, Jürgen et al,**
**Lennéstrasse 9 Postfach 24, D-8133 Feldafing(DE)**

## Description

La présente invention concerne un dispositif de ventilation des radiateurs de fluide et/ou des rhéostats de démarrage et de freinage d'une locomotive électrique ou d'une locomotive à moteurs à combustion interne et électrique, disposés en nappe à proximité de la toiture de la locomotive.

Actuellement, sur les locomotives à génération de puissance par moteur à combustion interne (généralement moteur Diesel), la ventilation par de l'air des réfrigérants d'eau (si on se sert de l'eau comme fluide caloporteur), ou directement des réfrigérants d'huile, est assurée par un ou plusieurs ventilateurs axiaux.

Deux dispositions sont couramment utilisées :
- soit les réfrigérants sont disposés verticalement en nappes au-dessus du châssis de la locomotive, parallèlement aux faces latérales, plaqués contre celles-ci ou légérement en retrait,
- soit ils sont placés en nappes horizontales et à proximité de la toiture de la locomotive.

Dans la première variante, le ou les ventilateurs sont axiaux et montés suivant des axes verticaux ; les diffuseurs ou même quelquefois les viroles de guidage de l'air sont logés directement dans des ouvertures découpées dans la toiture de la locomotive. Les ventilateurs aspirent alors l'air ambiant à travers les réfrigérants.

Dans la seconde variante, le ou les ventilateurs sont axiaux et placés sous la nappe des réfrigérants. Ils sont en général montés suivant un axe vertical et soufflent sous les réfrigérants, la canalisation d'air entre la virole du ventilateur et les réfrigérants étant en forme de pseudo-tronc de pyramide à grande base rectangulaire et petite base circulaire.

Dans l'une et l'autre de ces variantes, il est nécessaire pour assurer un bon fonctionnement de la ventilation de dégager de tout obstacle le volume environnant la zone d'aspiration des hélices, et si possible de guider par des déflecteurs les filets d'air à l'aspiration.

Dans la seconde variante, la hauteur de canalisation d'air entre virole de ventilateur et surface de réfrigération doit être suffisante pour permettre la meilleure répartition possible du débit d'air, qui, issu initialement d'une surface circulaire, doit refroidir une surface rectangulaire.

Que ce soit dans l'une ou l'autre de ces variantes, l'installation de refroidissement du moteur à combustion interne, suivant les dispositions définies ci-dessus, a pour conséquence la nécessité de disposer d'un volume important pour son installation et son environnement. En effet, pour qu'un ventilateur axial présente un fonctionnement et un rendement convenables, il faut que la direction des filets d'air aspirés et refoulés soit le plus possible parallèle à l'axe de l'hélice.

Afin de concilier les conditions suivantes :
- ventiler au mieux les surfaces rectangulaires des réfrigérants
- bénéficier au mieux de la plus grande largeur disponible dans la locomotive, tout en restant compatible avec les sections droites des passages longitudinaux nécessaires
- limiter à une quantité minimale le nombre des ventilateurs pour que leur coût reste acceptable, Il est habituel d'utiliser des hélices de grand diamètre (de 1 mètre à 1 m,50). Il est courant que ces hélices, pour le régime de puissance maximale demandé au moteur à combustion interne, tournent à des vitesses de 1500 à 2400 tours/min.

Il a été mesuré sur des locomotives en fonctionnement à poste fixe et dont le moteur (moteur Diesel) n'avait pas reçu d'aménagement particulier pour l'insonorisation (ni silencieux d'échappement, ni revêtement insonorisant sur les parois du compartiment) que le bruit émis à l'extérieur par les ventilateurs de réfrigération était équivalent à celui émis par le moteur lui-même. Ces ventilateurs sont donc la source d'une puissance phonique importante. Par ailleurs, l'air est aspiré au niveau de la partie inférieure de la locomotive dans une zone où il est relativement pollué, notamment par des poussières et par des vapeurs de combustible liquide.

Pour la ventilation des rhéostats de démarrage et de freinage, présents aussi bien sur les locomotives électriques que sur celles à moteur à combustion interne, on utilise en général la variante dans laquelle les ventilateurs axiaux refoulent l'air vers les résistances. Mais on retrouve sensiblement le même inconvénient d'un fonctionnement très bruyant et de l'aspiration d'un air relativement pollué.

Il est connu, du document CH-A 256 999, un dispositif de ventilation des radiateurs de fluide d'une locomotive à moteur à combustion interne disposés en nappe à proximité de la toiture de la locomotive, comprenant un ventilateur d'axe horizontal placé longitudinalement par rapport à la locomotive.

La présente invention a pour but de procurer des dispositifs de ventilation des radiateurs de fluide annexes à un moteur à combustion interne d'une locomotive, et/ou des rhéostats de démarrage et de freinage d'une locomotive électrique ou à moteur à combustion interne, qui engendrent un bruit bien plus faible que les dispositifs connus, tout en occupant un volume moins important et en assurant la même efficacité de refroidissement.

Le dispositif de ventilation selon l'invention est caractérisé en ce qu'il comprend au moins un ventilateur transverse d'axe horizontal placée longitudinalement par rapport à la locomotive, refoulant l'air vers les radiateurs de fluide et/ou les rhéostats, et des ouvertures d'aspiration d'air placées dans les faces latérales de la locomotive.

Il répond en outre de préférence à au moins l'une des caractéristiques suivantes :
- Le ventilateur transverse est disposé peu au-dessous des radiateurs de fluide et/ou des rhéostats, et les ouvertures d'aspiration d'air sont placées dans les parties hautes des faces latérales.
- Les rhéostats sont disposés au-dessus des radiateurs de fluide sous la toiture de la locomotive.
- Les ouvertures d'aspiration d'air et les radiateurs de fluide et/ou les rhéostats sont placés par rapport au ventilateur transverse de façon que l'air aspiré par celui-ci suive un trajet sensiblement horizontal jusqu'à ce ventilateur, puis vertical de ce dernier aux radiateurs et/ou aux rhéostats.
- Le dispositif comprend deux ventilateurs transverses et un volute triangulaire disposé entre ces deux ventilateurs et délimitant avec des crosses latérales deux chambres d'accès de l'air refoulé par les ventilateurs aux radiateurs de fluide et/ou rhéostats de démarrage et de freinage, dont la somme des sections de sortie est égale à la surface à ventiler des radiateurs de fluide et/ou rhéostats de démarrage.
- Pour la ventilation des rhéostats d'une locomotive électrique ou d'une locomotive à moteurs à combustion interne et électrique, disposés en nappes verticales sous la toiture de la locomotive à proximité d'une ouverture latérale, le ventilateur transverse est disposé sous la toiture de la locomotive au même niveau que les rhéostats.
- Deux ventilateurs transverse en parallèle sont entraînés par un même moteur à deux bouts d'arbre.

L'invention trouve aussi une application dans la ventilation d'appareils électriques dissipant de la chaleur rassemblés à l'intérieur d'armoires, elles-mêmes placées dans le compartiment des machines. Elle répond alors à au moins l'une des caractéristiques suivantes :
- Le dispositif comporte dans la zone longitudinale médiane de la locomotive une armoire contenant des appareils électriques à ventiler et reliée dans sa partie inférieure par au moins une ouverture à une zone latérale adjacente à une face latérale de la locomotive, munie d'une ouverture d'aspiration d'air.
- Pour la ventilation des rhéostats d'une locomotive électrique ou d'une locomotive à moteurs à combustion interne et électrique, disposés en nappe oblique sous la toiture de la locomotive à proximité d'une ouverture parallèle, le ventilateur transverse est disposé par rapport aux rhéostats latéralement et à un niveau inférieur.
- Il comporte dans la zone longitudinale médiane de la locomotive une armoire contenant des appareils électriques à ventiler, reliée par une ouverture inférieure à un fond contenant un transformateur électrique muni de réfrigérants de son huile de refroidissement, et relié à travers ceux-ci aux planchers grillagés de compartiments latéraux adjacents aux faces latérales de la locomotive, munies d'ouvertures d'aspiration d'air.

La présente invention fait appel à l'emploi de ventilateurs d'un type différent de celui des ventilateurs axiaux, mais connu en lui-même sous le nom de ventilateurs transverses, de ventilateurs tangentiels, de ventilateurs diamétraux, ou de ventilateurs de Mortier du nom de leur inventeur.

La roue du ventilateur transverse dans le dispositif de l'invention a son axe de rotation horizontal, légèrement décalé par rapport au plan vertical de symétrie de la surface des éléments à ventiler. Par contre sa longueur est sensiblement identique à celle des éléments à ventiler. La section de sortie du conduit de refoulement du ventilateur est donc constituée par un rectangle de grande longueur dans lequel le champ de vitesse de l'air est uniforme et parfaitement laminaire, à la différence du cas d'un ventilateur axial, qui communique à l'air un mouvement sensiblement hélicoïdal. Contrairement au ventilateur axial, où les axes de symétrie du courant d'air aspiré et du courant d'air refoulé sont confondus, le plan de symétrie du l'air aspiré dans le ventilateur est sensiblement perpendiculaire au plan de symétrie de l'air refoulé. En plaçant les éléments à refroidir et le dispositif de ventilation le plus haut possible dans la locomotive, l'invention procure deux avantages : d'une part dégager un volume maximal disponible pour loger de l'appareillage sous le dispositif de refroidissement, d'autre part aspirer l'air ambiant de préférence au niveau de la partie haute de la locomotive, où il est relativement peu pollué.

La réduction du bruit obtenue grâce à l'invention résulte du fait que par un choix convenable du diamètre de la roue du ou des ventilateurs, et pour un débit identique, on peut déterminer une vitesse de rotation de la roue trois à quatre fois inférieure à celle d'un ventilateur axial, ce qui réduit considérablement le bruit émis à l'extérieur.

Il est décrit ci-après, à titre d'exemple et en référence aux figures du dessin annexé, des dispositifs de ventilation des radiateurs de fluide d'une locomotive à moteur Diesel, des rhéostats de démarrage et de freinage d'une locomotive électrique, et simultanément des radiateurs de fluide et des rhéostats de démarrage et de freinage d'une locomotive Diesel-électrique.

La figure 1 représente en section droite le dispositif de ventilation des radiateurs de fluide d'une locomotive à moteur Diesel.

La figure 2 représente le même dispositif en élévation, après coupe selon l'axe II-II de la figure 1.

La figure 3 représente en section droite le dispositif de ventilation des rhéostats d'une locomotive électrique.

La figure 4 représente le même dispositif en élévation, après coupe selon l'axe IV-IV de la figure 3.

La figure 5 représente en section droite le dispositif de ventilation des radiateurs de fluide et des rhéostats d'une locomotive Diesel-électrique.

La figure 6 représente le même dispositif en élévation, après coupe selon l'axe VI-VI de la figure 5.

La figure 7 représente en section droite le dispostif de ventilation d'une locomotive électrique d'une rame à grande vitesse comprenant des appareils électriques à ventiler disposés dans une armoire.

La figure 8 représente une vue un élévation de deux ventilateurs transverses entraînés par un seul moteur vus dans le sens de la flèche F de la figure 7.

La figure 9 représente en section droite le dispositif de ventilation d'une locomotive électrique comprenant des appareils électriques à ventiler disposés dans une armoire et un transformateur.

La figure 10 représente une vue selon le plan de coupe de la figure 9 de quatre ventilateurs transverses couplés deux à deux sur un moteur à deux bouts d'arbre.

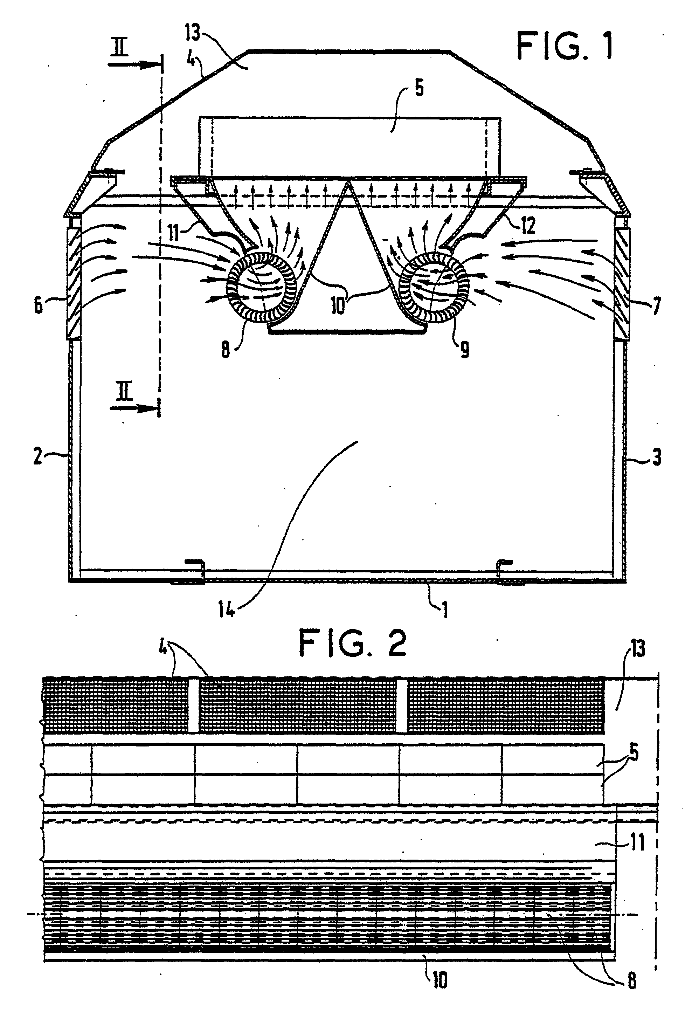

Dans les figures 1 et 2, la locomotive comporte un châssis 1, des faces latérales 2 et 3 et une toiture 4. Les radiateurs 5 d'eau de refroidissement du moteur ou les radiateurs d'huile sont disposés sous la toiture à proximité de celle-ci. L'air de ventilation est aspiré à travers des fenêtres latérales à persiennes 6, 7 vers les ventilateurs transverses 8, 9, disposés symétriquement par rapport au plan de symétrie de la locomotive et tournant en sens inverse par raison de symétrie.

Ceux-ci, d'axe horizontal parallèle à l'axe de la locomotive, sont fixés de part et d'autre d'une volute de forme triangulaire 10. Leur vitesse de rotation est réglable en fonction du débit de réfrigération requis. Des crosses latérales 11, 12 délimitent une chambre d'accès de l'air refoulé par le ventilateur aux radiateurs 5. La somme des deux sections de sortie des conduits de refoulement est égale à la surface à ventiler des radiateurs. Comme représenté en figure 2, la toiture de la locomotive est munie de grilles d'évacuation de l'air réchauffé arrivant dans le volume 13 au-dessus des radiateurs. Tout le volume 14 situé entre les ventilateurs et leur volute commune d'une part, le plancher du châssis de caisse d'autre part, est disponible pour y installer une grande partie des autres appareils et blocs nécessaires au fonctionnement de la locomotive.

L'air aspiré à travers les fenêtres latérales 6, 7 suit le trajet sensiblement horizontal indiqué par les flèches et parvient aux ventilateurs 8, 9 qui le refoulent vers le haut suivant les directions indiquées par les flèches.

Après avoir traversé les surfaces d'échange de chaleur des radiateurs 5, il est évacué du volume 13 à travers les grilles de la toiture 4.

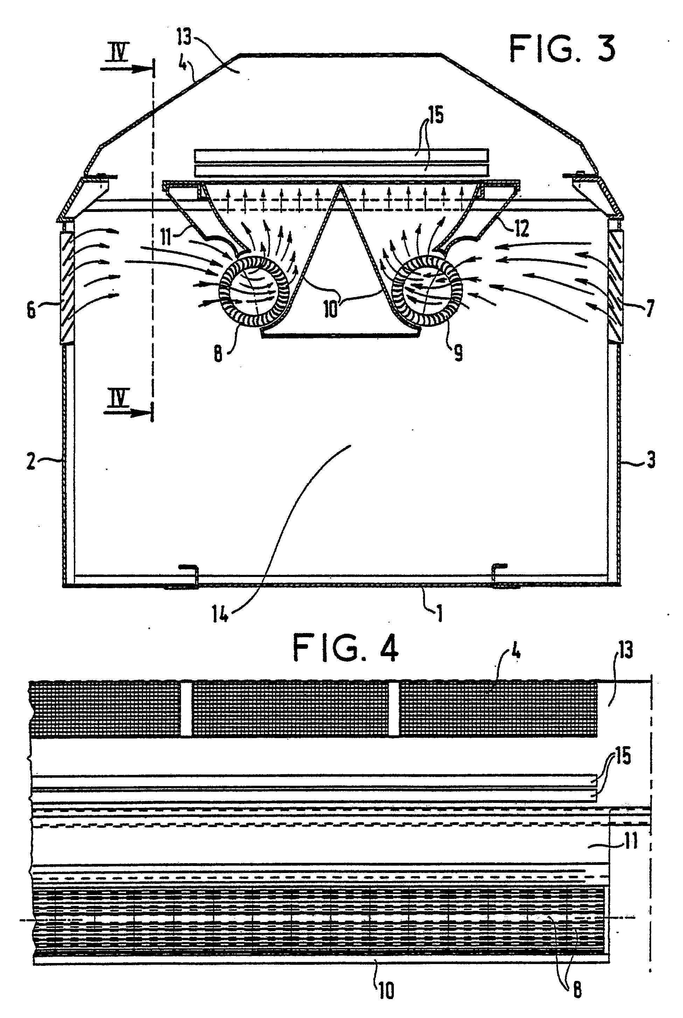

Dans le dispositif pour locomotive électrique représenté en figures 3 et 4, les organes sont sensiblement les mêmes que ceux du dispositif des figures 1 et 2, mais ce sont les rhéostats de démarrage et de freinage 15 qui sont ventilés par l'air refoulé vers le haut par les ventilateurs transverses 8, 9 entre le volute 10 et les crosses 11, 12.

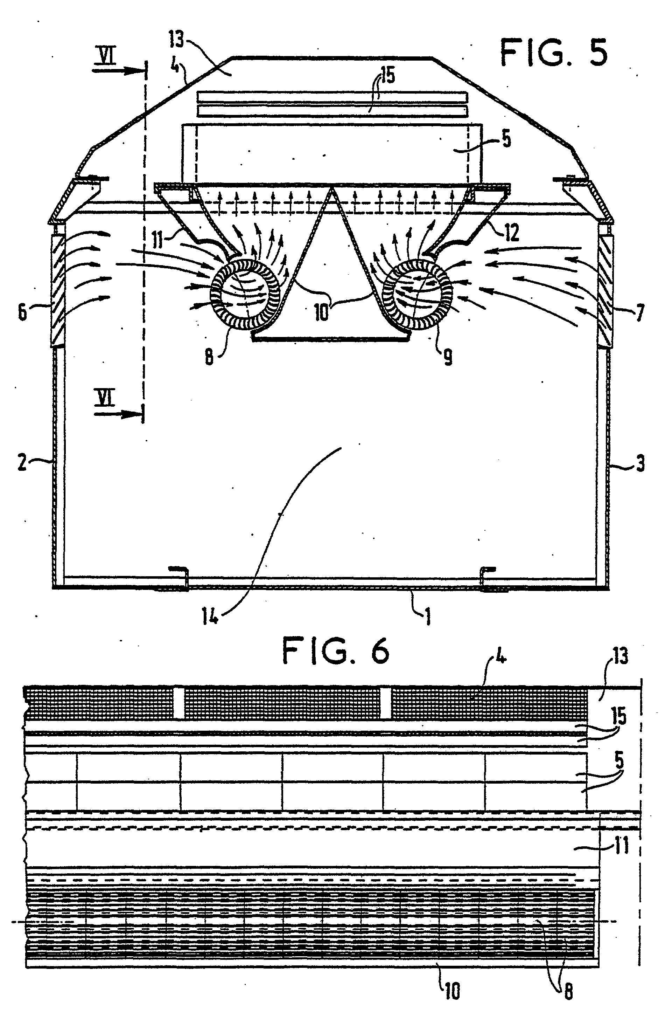

Dans le dispositif pour locomotive Diesel électrique représenté en figures 5 et 6, les organes sont sensiblement les mêmes que ceux des dispositifs des figures 1 et 2, 3 et 4, mais ce sont à la fois les radiateurs 5 de refroidissement des fluides du moteur Diesel et les rhéostats de démarrage et de freinage 15 qui sont ventilés par l'air refoulé vers le haut par les ventilateurs tranverses 8 et 9. Les deux sousensembles à ventiler ne demandent pas forcément le même ventilation simultanément. C'est celui qui à un instant donné requiert le débit d'air le plus important qui commande la régulation de vitesse des ventilateurs.

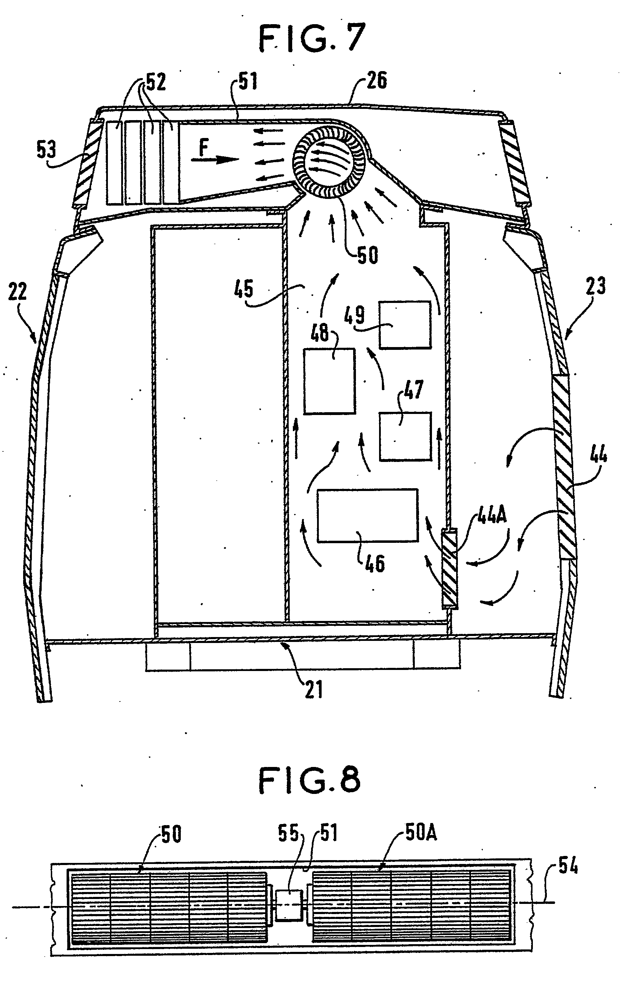

Dans la figure 7, la caisse de la locomotive comporte dans la partie inférieure de sa face latérale 23 des ouvertures 44 d'admission d'air de ventilation à persiennes. Cet air se rend par un passage 44A à débit réglable par des persiennes au bas d'une armoire verticale 45, dans laquelle il s'élève en refroidissant divers organes électriques 46, 47, 48, 49 comme représenté par les flèches. Il parvient en haut de cette gaine aux ventilateurs transverses 50, qui le refoulent latéralement, sensiblement à angle droit, dans la gaine 51, à l'extrémité de laquelle sont disposés en nappes verticales successives les rhéostats de démarrage et de freinage 52. Il s'échappe à l'extérieur par des ouvertures pratiquées dans le flanc 53 du toit de la locomotive.

La figure 8 représente en élévation les ventilateurs transverses 50, 50A, vus dans le sens de la flèche F de la figure 7. Ils tournent autour d'un axe horizontal longitudinal 54, entraînés par un seul moteur 55 à deux bouts d'arbre d'entraînement.

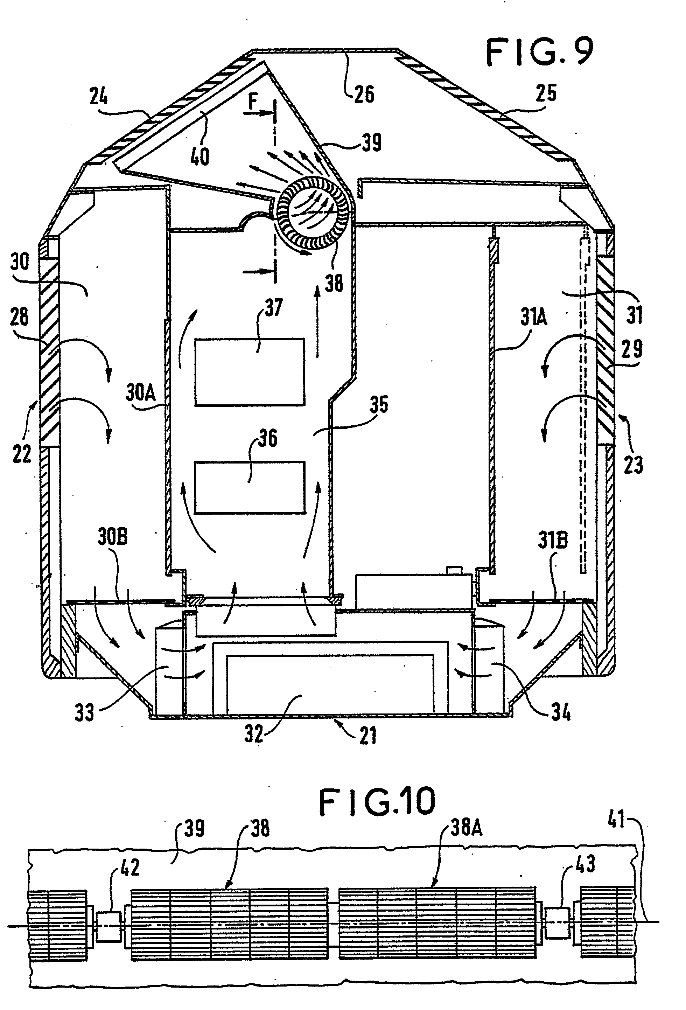

Dans la figure 9, la caisse de la locomotive comporte deux faces latérales 22 et 23, un fond 21 et une toiture 26, à flancs inclinés 24 et 25. Les faces latérales 22 et 23 sont munies d'ouvertures d'entrée d'air de ventilation à persiennes 27, 28, 29. Celles-ci débouchent dans deux couloirs latéraux 30, 31, délimités par des cloisons 30A, 31A, dans lesquels l'air s'écoule vers le bas, comme représenté par les flèches.

Il est disposé dans la zone inférieure de la locomotive un transformateur 12, muni de chaque côté de réfrigérants de son huile de refroidissement 33, 34.

Les flux d'air de ventilation, après avoir traversé les grillages 30B, 31B formant les planchers des couloirs latéraux, passent au contact des réfrigérants à huile 33, 34 puis s'élèvent dans une armoire verticale commune 35, dans laquelle son disposés des organes électriques à refroidir 36, 37 , tels que des condenseurs pour réfrigérants de semi-conducteurs de puissance, des inductances, etc...

Le flux d'air de ventilation parvient alors aux ventilateurs transverses 38 d'axe horizontal longitudinal, autour duquel ils tournent dans le sens trigonométrique, et qui le refoulent à l'intérieur de la gaine 39 dans la direction indiquée par les flèches, vers les rhéostats de démarrage et de freinage 40, à proximité immédiate du flanc latéral 24 du toit de la voiture de la locomotive.

La figure 10 représente une vue selon le plan de coupe F de la figure 9 de quatre ventilateurs transverses tels que 38, 38A, rotatifs autour de l'axe longitudinal 41. Ils sont couplés deux à deux sur un moteur à deux bouts d'arbre. Les moteurs 42 et 43 entraînent chacun les deux ventilateurs de part et d'autre de lui. Cette disposition est nécessaire quand la longueur du rectangle des grilles de rhéostats devient trop importante, ou bien quand il faut isoler partiellement la ventilation.

**Revendications**

1. Dispositif de ventilation des radiateurs de fluide (5) et/ou des rhéostats de démarrage et de freinage (15) d'une locomotive électrique ou d'une locomotive à moteurs à combustion interne et électrique, disposés en nappe à proximité de la toiture (4) de la locomotive, caractérisé en ce qu'il comprend au moins un ventilateur transverse (8, 9) d'axe horizontal placé longitudinalement par rapport à la locomotive, refoulant l'air vers les radiateurs de fluide et/ou les rhéostats, et des ouvertures d'aspiration d'air (6, 7) placées dans les faces latérales (2, 3) de la locomotive.

2. Dispositif selon la revendication 1, caractérisé en ce que le ventilateur transverse (8, 9) est disposé peu au-dessous des radiateurs de fluide (5) et/ou des rhéostats (15), et en ce que les ouvertures d'aspiration d'air sont placées dans les parties hautes des faces latérales.

3. Dispositif selon les revendications 1 ou 2, caractérisé en ce que les rhéostats (15) sont disposés au-dessus des radiateurs de fluide (5) sous la toiture (4) de la locomotive.

4. Dispositif selon l'une des revendications 1 à 3, caractérisé en ce que les ouvertures d'aspiration d'air (6, 7) et les radiateurs de fluide (5) et/ou les rhéostats (15) sont placés par rapport au ventilateur transverse (8, 9) de façon que l'air aspiré par celui-ci suive un trajet sensiblement horizontal jusqu'à ce ventilateur, puis vertical de ce dernier aux radiateurs et/ou aux rhéostats.

5. Dispositif selon l'une des revendications 1 à 4, caractérisé en ce qu' il comprend deux ventilateurs transverses (8, 9) et un volute triangulaire (10) disposé entre deux ventilateurs (8, 9) et délimitant avec des crosses latérales (11, 12) deux chambres d'accès de l'air refoulé par les ventilateurs aux radiateurs de fluide et/ou rhéostats de démarrage et de freinage, dont la somme des sections de sortie est égale à la surface à ventiler des radiateurs de fluide et/ou rhéostats de démarrage.

6. Dispositif selon la revendication 1, pour la ventilation des rhéostats (52) d'une locomotive électrique, ou d'une locomotive à moteurs à combustion interne et électrique, disposés en nappes verticales sous la toiture de la locomotive (4) à proximité d'une ouverture latérale d'évacuation de l'air réchauffé (53), caractérisé en ce que le ventilateur transverse est disposé sous la toiture de la locomotive au même niveau que les rhéostats.

7. Dispositif selon la revendication 6, caractérisé en ce qu'il comporte dans la zone longitudinale médiane de la locomotive une armoire (45) contenant des appareils électriques à ventiler (46, 47, 48, 49) et reliée dans sa partie inférieure par au moins une ouverture (44A) à une zone latérale adjacente à une face latérale (23) de la locomotive, munie d'une ouverture d'aspiration d'air (44).

8. Dispositif selon la revendication 1, pour la ventilation des rhéostats (40) d'une locomotive électrique ou d'une locomotive à moteurs à combustion interne et électrique, disposés en nappe oblique sous la toiture (4) de la locomotive à proximité d'une ouverture parallèle d'évacuation de l'air réchauffé (24), caractérisé en ce que le ventilateur transverse (38) est disposé par rapport aux rhéostats latéralement et à un niveau inférieur.

9. Dispositif selon la revendication 8, caractérisé en ce qu'il comporte dans la zone longitudinale médiane de la locomotive une armoire (35) contenant des appareils électriques à ventiler (36, 37), reliée par une ouverture inférieure à un fond (21) contenant un transformateur électrique (32) muni de réfrigérants (33, 34) de son huile de refroidissement, et relié à travers ceux-ci aux planchers grillagés (30B, 31B) de compartiments latéraux (30, 31) adjacents aux faces latérales (22, 23) de la locomotive, munies d'ouvertures d'aspiration d'air (28, 29).

10. Dispositif selon l'une des revendications 1 à 9, caractérisé en ce que deux ventilateurs transverses (50, 50A) en parallèle sont entraînés par un même moteur (55) à deux bouts d'arbre.

## Patentansprüche

1. Vorrichtung zum Belüften von Fluidkühlern (5) und/oder Anfahr- und Bremsrheostaten (15) einer Elektrolokomotive oder einer kombinierten Brennkraft-Elektrolokomotive, wobei diese Kühler flach ausgebildet und in der Nähe des Daches (4) der Lokomotive angeordnet sind, dadurch gekennzeichnet, daß die Vorrichtung mindestens einen Querlüfter (8, 9) mit waagrechter, in Längsrichtung zur Lokomotive angeordneter Achse, der die Luft gegen die Fluidkühler und/oder Rheostaten bläst, und Luftansaugöffnungen (6, 7) in den Seitenflächen (2, 3) der Lokomotive aufweist.

2. Vorrichtung nach Anspruch 1, dadurch gekennzeichnet, daß der Querlüfter (8, 9) knapp unterhalb der Fluidkühler (5) und/oder der Rheostaten (15) angeordnet ist und daß die Luftansaugöffnungen in den oberen Partien der Seitenflächen angebracht sind.

3. Vorrichtung nach Anspruch 1 oder 2, dadurch gekennzeichnet, daß die Rheostaten (15) oberhalb der Fluidkühler (5) unter dem Dach (4) der Lokomotive angeordnet sind.

4. Vorrichtung nach einem der Ansprüche 1 bis 3, dadurch gekennzeichnet, daß die Luftansaugöffnungen (6, 7) und die Fluidkühler (5) und/oder Rheostaten (15) in bezug auf den Querlüfter (8, 9) derart angeordnet sind, daß die von diesem angesaugte Luft bis zum Lüfter einen im wesentlichen waagrechten Weg und von da aus einen senkrechten Weg zu den Kühlern und/oder Rheostaten nimmt.

5. Vorrichtung nach einem der Ansprüche 1 bis 4, dadurch gekennzeichnet, daß sie zwei Querlüfter (8, 9) und ein dreieckiges Leitblech (10) aufweist, das zwischen den beiden Querlüftern (8, 9) angeordnet ist und zusammen mit Seitenschalen (11, 12) zwei Eintrittskammern für die Luft begrenzt, die von den Lüftern gegen die Fluidkühler und/oder die Anfahr- und Bremsrheostaten geblasen wird, wobei die Summe der Austrittsquerschnitte der Größe der zu kühlenden Oberfläche der Fluidkühler und/oder der Anfahrrheostaten gleicht.

6. Vorrichtung nach Anspruch 1 zur Belüftung der Rheostaten (52) einer Elektrolokomotive oder einer kombinierten Brennkraft-Elektrolokomotive, bei der die Rheostaten flach ausgebildet und senkrecht unter dem Dach (4) der Lokomotive in der Nähe einer seitlichen Auslaßöffnung (53) für erwärmte Luft angeordnet sind, dadurch gekennnzeichnet, daß der Querlüfter unter dem Dach der Lokomotive auf gleicher Höhe wie die Rheostaten angeordnet ist.

7. Vorrichtung nach Anspruch 6, dadurch gekennzeichnet, daß sie in der Mitte der Längszone der Lokomotive einen Schrank (45) mit zu belüftenden elektrischen Geräten (46, 47, 48, 49) aufweist, der mit seinem Unterteil über mindestens eine Öffnung (44A) mit einer Seitenzone neben einer Seitenfläche (23) der Lokomotive in Verbindung steht, und die Seitenzone eine Luftansaugöffnung (44) besitzt.

8. Vorrichtung nach Anspruch 1, zur Belüftung der Rheostaten (40) einer Elektrolokomotive oder einer kombinierten Brennkraft-Elektrolokomotive, bei der diese Rheostaten in schräger Lage unter dem Dach (4) der Lokomotive in der Nähe einer parallelen Luftaustrittsöffnung (24) für erwärmte Luft angeordnet sind, dadurch gekennzeichnet, daß der Querlüfter (38) in bezug auf die Rheostaten seitlich und in einer geringeren Höhe angeordnet ist.

9. Vorrichtung nach Anspruch 8, dadurch gekennzeichnet, daß sie in der Mitte der Längszone der Lokomotive einen Schrank (35) mit zu belüftenden elektrischen Geräten (36, 37) aufweist, der über eine untere Öffnung mit einem Bodenraum (21) in Verbindung steht, welcher einen elektrischen Transformator (32) mit Kühlern (33, 34) für sein Öl enthält, und daß der Schrank über diese Kühler mit Gitterböden (30B, 31B) der Seitenabteile (30, 31) neben den Seitenflächen (22, 23) der Lokomotive in Verbindung steht und daß die Seitenflächen Luftansaugöffnungen (28, 29) besitzen.

10. Vorrichtung nach einem der Ansprüche 1 bis 9, dadurch gekennzeichnet, daß zwei parallele Querlüfter (50, 50A) vom gleichem Motor (55) über zwei Wellenstümpfe angetrieben werden.

**Claims**

1. A device for ventilating fluid radiators (5) and/or starting and braking rheostats (15) in a locomotive driven electrically or by means both of an internal combustion engine and electrical motors, said radiators and/or rheostats being disposed in a layer in the proximity of the roof (4) of the locomotive, characterized in that it comprises at least one transverse fan (8, 9) having a horizontal axis placed longitudinally relative to the locomotive and blowing air towards the said fluid radiators and/or rheostats, and air intake openings (6, 7) placed in the side faces (2, 3) of the locomotive.

2. A device according to claim 1, characterized in that the transverse fan (8, 9) is disposed slightly below said fluid radiators (5) and/or rheostats (15), and in that said air intake openings are placed near the tops of the side walls.

3. A device according to claim 1 or 2, characterized in that said rheostats (15) are disposed above said fluid radiators (5) and beneath the roof (4) of the locomotive.

4. A device according to anyone of the claims 1 to 3, characterized in that the air intake openings (6, 7) and the fluid radiators (5) and/or the rheostats (15) are placed relative to the transverse fan in such a manner that the air is sucked along a substantially horizontal path towards the fan and then along a substantially vertical path towards the radiators and/or rheostats.

5. A device according to anyone of the claims 1 to 4, characterized in that it comprises two transverse fans (8, 9) and a triangular volute (10) disposed between said two fans; (8, 9) and delimiting together with side baffles (11, 12) two access chambers for air blown by the fans towards the fluid radiators and/or the starting or braking rheostats, the sum of the outlet sections being equal to the surface to be ventilated of the fluid radiators and or starting rheostats.

6. A device according to claim 1, for ventilating the rheostats (52) of an electric locomotive or of a combined internal combustion engine and electric locomotive, said rheostats being disposed in vertical layers beneath the roof (4) of the locomotive in the vicinity of a side opening (53) for exhausting heated air, characterized in that the transverse fan is disposed beneath the roof of the locomotive at the same level as the rheostats.

7. A device according to claim 6, characterized in that it includes a cabinet (45) occupying a longitudinally extending middle region of the locomotive and housing electrical apparatus (46, 47, 48, 49) to be ventilated, the bottom of said housing being connected via at least one opening (44A) to a lateral area adjacent to the side face (23) of the locomotive having an air intake opening (44) therethrough.

8. A device according to claim 1, for ventilating rheostats (40) of an electric locomotive or of a combined internal combustion engine and electric locomotive, said rheostats being disposed in sloping layers beneath the roof (4) of the locomotive in the proximity of a parallel opening (24) for exhausting heated air, characterized in that the transverse fan (38) is disposed below and to one side of said rheostats.

9. A device according to claim 8, characterized in that it includes a cabinet (35) occupying a longitudinally extending middle region of the locomotive and housing electrical apparatus (36, 37) to be ventilated, said cabinet being connected via a bottom opening to a bottom chamber (21) containing an electrical transformer (32) provided with heat exchangers (33, 34) for cooling its oil, and being connected via said heat exchangers to floor grids (30B, 31B) of side compartments (30, 31) adjacent to the side faces (22, 23) of the locomotive and fitted with the air intake openings (28, 29).

10. A device according to anyone of the claims 1 to 9, characterized in that two transverse fans (50, 50A) are driven by a single motor (55) having two shaft ends extending therefrom.

# FIG. 1

# FIG. 2

FIG. 3

FIG. 4

FIG. 5

FIG. 6

# FIG. 7

# FIG. 8

# FIG.9

# FIG.10